Europäisches Patentamt

(19) European Patent Office    (11) Numéro de publication: **0 206 900**

Office européen des brevets    **B1**

(12)    **FASCICULE DE BREVET EUROPEEN**

(45) Date de publication du fascicule du brevet: **26.09.90**    (51) Int. Cl.⁵: **H 03 M 1/26**

(21) Numéro de dépôt: **86401252.1**

(22) Date de dépôt: **10.06.86**

(54) Dispositif de lecture de code optique, notamment du type entièrement intégré.

(30) Priorité: **14.06.85 FR 8509076**

(43) Date de publication de la demande:
**30.12.86 Bulletin 86/52**

(45) Mention de la délivrance du brevet:
**26.09.90 Bulletin 90/39**

(84) Etats contractants désignés:
**AT BE CH DE GB IT LI LU NL SE**

(56) Documents cités:
**EP-A-0 102 241**
**FR-A-1 404 822**
**US-A-2 966 671**
**US-A-4 137 451**
**US-A-4 312 071**

**IRE TRANSACTIONS ON INSTRUMENTATION,
vol. PGI-5, juin 1956, pages 168-173, New York,
US; W.I. FRANK et al.: "Precision shaft-position
encoders"**

(73) Titulaire: **M C B**
**11, rue Pierre Lhomme**
**F-92400 Courbevoie (FR)**

(72) Inventeur: **Perrot, Jean-Claude**
**8 Allée des Primevères**
**F-95370 Montigny en Cormeilles (FR)**
Inventeur: **Taillebois, Jacques Résidence Brigitte**
**23 Rue des Ebisoires**
**F-78370 Plaisir (FR)**

(74) Mandataire: **Lecca, Jean et al**
**CABINET PLASSERAUD 84, rue d'Amsterdam**
**F-75009 Paris (FR)**

(56) References cited:
**MACHINE DESIGN, vol. 54, no. 24, octobre 1982,
pages 105-109, Cleveland, Ohio, US; N.
WALKER: "Guarding against errors in optical
encoders"**

Courier Press, Leamington Spa, England.

# Description

La présente invention concerne un dispositif de lecture absolue d'un code optique porté notamment par un disque à pistes codées, la lecture ayant lieu dans ce cas par diascopie, c'est-à-dire par lecture différentielle des zones transparentes et des zones opaques du disque, disposées suivant un code connu dans la technique sous le nom de code Gray.

On sait qu'un tel dispositif comprend en combinaison avec un disque comportant plusieurs pistes concentriques chacune avec une succession de zones opaques et de zones transparentes fines alternantes au moins une source de lumière apte à éclairer l'ensemble des pistes et un ensemble lecteur de code proprement dit qui émet des impulsions électriques représentant finalement la position angulaire relative de deux éléments d'un ensemble mobiles l'un par rapport à l'autre, le disque étant porté par l'un de ces éléments.

Les dispositifs de lecture de code optique sont de plus en plus utilisés, une de leurs applications (à laquelle s'applique particuliérement l'invention) étant celle de détermination de la position angulaire d'éléments mobiles d'un robot, en prévoyant, dans ce cas, un dispositif de lecture par élément mobile.

Bien que l'invention s'applique particuliérement à la lecture d'un disque codé par diascopie, c'est-à-dire par transparence, elle peut également s'appliquer à la lecture d'un disque codé par réflexion, et également à la lecture d'une réglette codée en déterminant alors non pas une position angulaire mais un déplacement linéaire relatif entre deux éléments, dont l'un est mobile en translation par rapport à l'autre, la réglette étant portée par un de ces deux éléments.

Dans la suite de la présente description on se limitera au cas de la lecture par diascopie d'un disque codé comportant plusieurs pistes mettant en oeuvre le code Gray.

Classiquement, un dispositif de lecture d'un disque codé comprend

d'une part, au moins une source de lumière constituée soit par une lampe à filament émettant de la lumière dans un spectre large comportant le visible et le proche infrarouge (le proche infrarouge étant la zone de sensibilité maximale pour les photodétecteurs, notamment au silicium), la lampe à filament éclairant, à travers un systéme optique approprié, l'ensemble des pistes du disque, soit un ensemble de diodes émettrices de lumière généralement dans le proche infrarouge (dans la bande de 0,8 à 0 microns)

d'autre part, un ensemble lecteur de code proprement dit, qui coopère avec le disque codé et la source de lumière ou les sources de lumière, et qui comprend d'abord une série de photodétecteurs en nombre égal au nombre de pistes, ces photodétecteurs étant constitués notamment par des photodiodes ou des phototransistors qui se présentent soit sous forme de composants discrets, soit disposés dans un boitier commun; dans les deux cas le nombre des photodétecteurs est égal au nombre des diodes émettrices de lumière lorsque la source de lumière est constituée par de telles diodes.

Les photodétecteurs de la technique antérieure débitent des signaux trés faibles et de ce fait ils sont suivis par des amplificateurs, notamment par des amplificateurs opérationnels du commerce constitués par des circuits intégrés avec des composants discrets câblés sur un circuit imprimé, ou bien on met en oeuvre des circuits hybrides ou "prédiffusés" spécifiques comportant en général autant d'amplificateurs qu'il y a de pistes codées et donc de photodétecteurs (ciaprés on parlera de voies de lecture, à savoir une voie par piste du disque codé).

Dans chaque voie l'amplificateur est suivi classiquement par un circuit de mise en forme constitué en général par un trigger du type bascule de Schmitt donnant en sortie des impulsions à front raide en réponse à chaque zone transparente de la piste correspondant à la voie en question. Avantageusement on dispose dans un même boitier l'ensemble des bascules de Schmitt, et même plus avantageusement encore l'ensemble des amplificateurs et l'ensemble des bascules de Schmitt soit suivant la technique hybride, soit suivant la technique des circuits prédiffusés, Il faut prévoir en outre pour chaque bascule de Schmitt, c'est-à-dire pour chaque voie, un élément de réglage destiné à ajuster le seuil de basculement de la bascule afin d'assurer, en dépit des variations de sensibilité des photodétecteurs, un bon fonctionnement de chaque voie et une bonne précision de la commutation des unités électroniques subséquentes.

En effet il est nécessaire, pour un grand nombre d'applications des dispositifs de lecture de code, d'effectuer des traitements logiques avant transmission des informations obtenues pour chaque voie par une chaine photodétecteur-amplificateur-bascule de Schmitt.

Notamment on prévoit en général:

des moyens de levée de doute (en particulier dans le cas des codeurs absolus multitours ou des codeurs monotours, lorsque le disque est codé non pas suivant le code Gray, mais suivant le code binaire naturel), ces moyens étant constitués par des circuits intégrés logiques du commerce;

des moyens de transcodage de code Gray (qui est celui figurant sur le disque codé) en code binaire naturel (qui est alors le code de sortie du dispositif de lecture) pour faciliter l'exploitation ultérieure des données du dispositif de lecture, ces moyens étant constitués par des circuits "OU exclusif" du commerce:

des moyens de génération d'un bit de parité pour valider la transmission du code lorsque le nombre de bits est conforme (soit pair, soit impair, suivant la convention), notamment lorsque la sortie du dispositif de lecture est une sortie série (après transformation des sorties parallèles des bascules de Schmitt en une sortie série), ces moyens étant constitués en général par un ensemble d'unités "OU exclusif" du commerce;

2

des moyens de transformation de sorties parallèles en sortie série pour diminuer le nombre des fils de liaison entre la sortie du dispositif de lecture et l'ensemble d'utilisation des informations de position, ces moyens étant constitués par un registre à décalage du commerce;

des moyens de décalage de l'origine destinés à remplacer le calage fin mécanique du disque par un réglage du zéro électrique, ces moyens étant constitués par des commutateurs codés.

La transmission des informations du dispositif de lecture est effectuée classiquement

soit par une transmission série, en utilisant, comme circuits d'interface, des émetteurs et des récepteurs de lignes qui sont constitués par des boitiers du commerce,

soit par une transmission parallèle des informations du dispositif de lecture sur un "bus", en utilisant alors une sortie à 3 états (l'état haut ne comportant pas de sortie d'information, tandis que les deux autres états représentent respectivement le bit "0" et le bit "1"), ou une sortie du type "collecteur ouvert", pour chaque voie, en utilisant des circuits du commerce.

Enfin la tension d'alimentation est réglée et filtrée à l'intérieur du dispositif de lecture et de la source de lumiére.

Il est en outre nécessaire, dans la plupart des cas, de compenser les fluctuations ou les dérives de la source de lumière unique ou des sources de lumière pour assurer un bon fonctionnement de l'ensemble dans une large plage de températures.

L'ensemble de l'alimentation, de sa régulation et de sa filtration, d'une part, et de la compensation des fluctuations de la ou des sources de lumière, d'autre part, est réalisé classiquement au moyen de composants disponibles dans le commerce.

On réalise aisément que l'ensemble de lecture qui vient d'être décrit ci-dessus exige, dans la construction habituelle, un nombre important de composants qui, une fois câblés sur un circuit imprimé, occupent un volume important et coûtent relativement cher, et ceci en présentant une fiabilité limitée.

On a proposé, pour pallier ces inconvénients, de réaliser une hybridation de la partie électronique (amplificateurs, bascules de Schmitt, moyens logiques), ou bien de constituer la partie électronique en plusieurs grands blocs fonctionnels, en réalisant chacun de ces blocs sous la forme d'un circuit prédiffusé, ou bien encore d'effectuer un panachage d'hybridation et de circuits prédiffusés. Ces trois types de solutions permettent de réduire l'encombrement et d'améliorer la fiabilité, mais ne réduisent pratiquement pas le prix de l'ensemble du dispositif de lecture du code (source de lumière et dispositif de lecture proprement dit associé).

L'article publié dans IRE Transactions on Instrumentation, vol. P6 1—5, juin 1956, pages 168—173, par Frank et al décrit un codeur de la position d'un arbre, comportant une source unique de lumière, un disque codé à plusieurs pistes solidaire de l'arbre dont on veut mesurer la position et une série de cellules photoélectriques en correspondance avec chacune des pistes du disque codé. Les sorties binaires des cellules photoélectriques sont "sérialisées" grâce à un registre à décalage ayant des entrées parallèles et une sortie série, ce registre étant commandé par une unité de contrôle qui provoque le transfert successif des sorties en parallèle des cellules photoélectriques pour constituer un signal série disponible à la sortie du registre à décalage.

Par ailleurs, il est connu d'après l'article de Machine Design, vol. 54, n° 24, octobre 1982, pages 105—109, de Walker, d'améliorer la lecture d'un disque codé en prévoyant en regard de chaque piste du disque non pas une seule cellule ou détecteur photoélectrique mais deux cellules ou détecteurs conçus pour recevoir des signaux lumineux opposés (réception de lumière par l'un, absence de réception de lumière par l'autre) pour une zone de même type en regard sur la piste du disque, les sorties de ces deux détecteurs correspondant à une même piste étant appliquées à un amplificateur différentiel à deux entrées et une sortie, un trigger donnant un front raide aux signaux de sortie de l'amplificateur différentiel.

On connaît également des codeurs du type à contact et non pas à lecture optoélectronique d'un disque optique portant un code, un tel codeur étant décrit par exemple dans FR—A—1.404.822.

La présente invention vise à améliorer simultanément les trois facteurs précités (encombrement, fiabilité et coût) des dispositifs de lecture connus, en réduisant l'encombrement, en augmentant la fiabilité et en réduisant le coût, et ceci en permettant par ailleurs de tester l'ensemble du lecteur sans augmenter la complexité du système.

Pour ce faire, l'invention vise à réaliser les différents composants optoélectroniques (photodétecteurs), analogiques (amplificateurs, etc.) logiques (bascules, portes, etc.) et d'interface (portes 3 états, etc.) de manière à pouvoir intégrer ces composants sur une puce, ou éventuellement un nombre réduit de puces de silicium, en prévoyant en outre sur cette ou ces puces des moyens permettant de tester l'ensemble de lecture proprement dit et éventuellement des moyens réalisant d'autres fonctions.

On réduit ainsi considérablement la dimension et le coût du dispositif de lecture, tout en augmentant la fiabilité et en réduisant les fluctuations.

La présente invention a pour objet un dispositif de lecture de code optique — destiné à coopérer avec un élément codé, en mouvement relatif par rapport à ce dispositif de lecture et comportant une série de n pistes codées avec une succession de zones élémentaires de deux types de retransmission de lumière reçue — qui comprend;

une source unique de lumière pour éclairer la série de pistes,

des moyens de détermination d'éclairement pour déterminer si de la lumière est ou n'est pas retransmise par une zone élémentaire observée de chacune des pistes,

un registre à décalage à entrées parallèles recevant chacune un signal binaire indiquant si de la lumière est ou n'est pas retransmise par une telle zone élémentaire et à sortie série, et

au moins une unité de contrôle recevant des impulsions d'horloge à partir d'une horloge et des impulsions de transfert, la sortie de cette unité de contrôle commandant le fonctionnement du registre à décalage, caractérisé en ce que ledit élément codé comporte, en plus de la série de n pistes codées, une seconde série de n pistes, chacune de ces dernières pistes étant codée complémentairement à une des pistes de la première série, et en ce que lesdits moyens de détermination d'éclairement sont portés par 1 à p puces (p étant un nombre entier petit) et comportent en combinaison;

pour chacune des pistes de l'élément codé, une paire de photodiodes, un amplificateur différentiel dont les deux entrées reçoivent les signaux émis par les deux photodiodes, un trigger donnant un front avant raide aux signaux reçus de la sortie de l'amplificateur différentiel,

ledit registre à décalage, les entrées parallèles de celui-ci étant connectées à la sortie d'un amplificateur différentiel à travers le trigger associé, l'ensemble de ces sorties étant constitué par les bits représentatifs du code de chaque piste pour la zone lue, tandis que la sortie série dudit registre à décalage débite tous les bits correspondant à une position relative de l'élément codé et du dispositif de lecture, ainsi qu'un bit supplémentaire initial ou de départ, et

des moyens pour envoyer sur les photodiodes ou les entrées des amplificateurs différentiels des signaux aptes à simuler, sur la sortie des diodes ou l'entrée des amplificateus respectivement, à volonté le niveau de bit "0" ou "1".

Dans les modes de réalisation préférés l'élément, porteur de code est un disque et la lecture des zones opaques ou transparentes de celui-ci est effectuée par diascopie, c'est-à-dire par lumière transmise ou non transmise à travers les zones respectivement transparentes et opaques du disque.

Avantageusement:

l'amplificateur différentiel est en réalité constitué par deux amplificateurs en parallèle, recevant chacun la sortie d'une des deux photodiodes de la paire de photodiodes accouplées, et par un comparateur dont les deux entrées reçoivent chacune la sortie d'un des deux amplificateurs précités disposés en parallèle;

on prévoit un décalage d'amplitude, dans le basculement provoqué par la partie montante, d'une part, et la partie descendante, d'autre part, du signal sortant de l'amplificateur différentiel, c'est-à-dire une hystérésis du comparateur, dans le mode de réalisation préféré de cet amplificateur différentiel;

le registre à décalage comprend une entrée spéciale, en plus des entrées alimentées par les amplificateurs différentiels, notamment les comparateurs, cette entrée spéciale étant alimentée pour produire un bit initial ou de départ qui précéde les bits d'informations sur les zones de l'élément codé effectivement lues;

on prévoit que le dispositif de lecture comporte un transcodeur série de conversion du code Gray en code binaire naturel opérant, sous le contrôle de l'unité de contrôle, la conversion des bits en code Gray sortant du registre à décalage en bits en code binaire naturel disponibles sur un ètage de sortie du dispositif de lecture;

le dispositif de lecture comporte un générateur de parité qui engendre un bit de parité assurant que le nombre de "1" transmis par le registre à décalage à l'étage de sortie, éventuellement à travers le transcodeur de code Gray en code binaire naturel, présente une parité déterminée (ce nombre est effectivement pair ou impair), ce bit de parité étant introduit après les bits d'information;

le dispositif de lecture comporte un compteur programmable apte à choisir le nombre de bits d'informations utiles en fonction du nombre de pistes effectivement lues, ce compteur commandant, lorsqu'il existe, le générateur de parité pour la génération du bit de parité à l'instant désiré après le nombre de bits d'information sélectionné;

le dispositif de lecture comporte une mémoire tampon recevant sur son entrée le bit le plus significatif du registre à déclage pour chaque succession de bits correspondant à une position déterminée qui est lue, et un étage de sortie, connecté à la sortie de la mémoire tampon, pour la sortie de ce bit le plus significatif, la mémoire tampon étant contrôlée par l'unité de contrôle en ce qui concerne sa sortie;

le dispositif de lecture comporte un ensemble de verrous d'entrée disposés entre la sortie des amplificateurs différentiels, notamment des comparateurs, et l'entrée du registre à décalage, de manière à pouvoir transmettre les sorties des amplificateurs différentiels, respectivement des comparateurs, à un instant bien déterminé;

le dispositif de lecture comporte un inverseur du bit le plus significatif, commandable pour réaliser, lorsqu'on le désire, l'inversion de ce bit avant qu'il soit appliqué au registre à décalage.

L'invention pourra, de toute façon, être bien comprise à l'aide du complément de description qui suit, ainsi que des dessins ci-annexés, lesquels complément et dessins sont, bien entendu, donnés surtout à titre d'indication.

La figure 1 représente schématiquement, sous forme de blocs, un dispositif de lecture doté des perfectionnements selon l'invention, complètement intégrable, pour 8—10 bits, avec sortie série, la source de lumière n'étant pas représentée.

La figure 2 représente une des voies de lecture en amont du registre à décalage.

La figure 3 illustre des signaux pénétrant dans le comparateur de la figure 2.

La figure 4 illustre des impulsions sortant du trigger ou bascule de la figure 1.

La figure 5 représente les signaux de sortie série en fonctionnement normal, ainsi que les impulsions d'autorisation de transfert et d'horloge déclenchant le fonctionnement normal de l'appareil.

La figure 6 illustre de même les signaux de sortie série, les impulsions d'autorisation de transfert et d'horloge et en outre les impulsions de contrôle, dans le cas du fonctionnement du dispositif de lecture en mode test.

La figure 7, enfin, représente schématiquement, sous forme de blocs, un dispositif de lecture doté des perfectionnements selon l'invention, complètement intégrable, pour 12—14 bits, avec sortie parallèle ou série, la source de lumière n'étant pas représentée.

Selon l'invention et plus spécialement selon celui de ses modes d'application, ainsi que selon ceux des modes de réalisation de ses diverses parties, auxquels il semble qu'il y ait lieu d'accorder la préférence, se proposant, par exemple, de réaliser un dispositif de lecture de code optique, notamment du type entièrement intégré, on s'y prend comme suit ou d'une manière analogue.

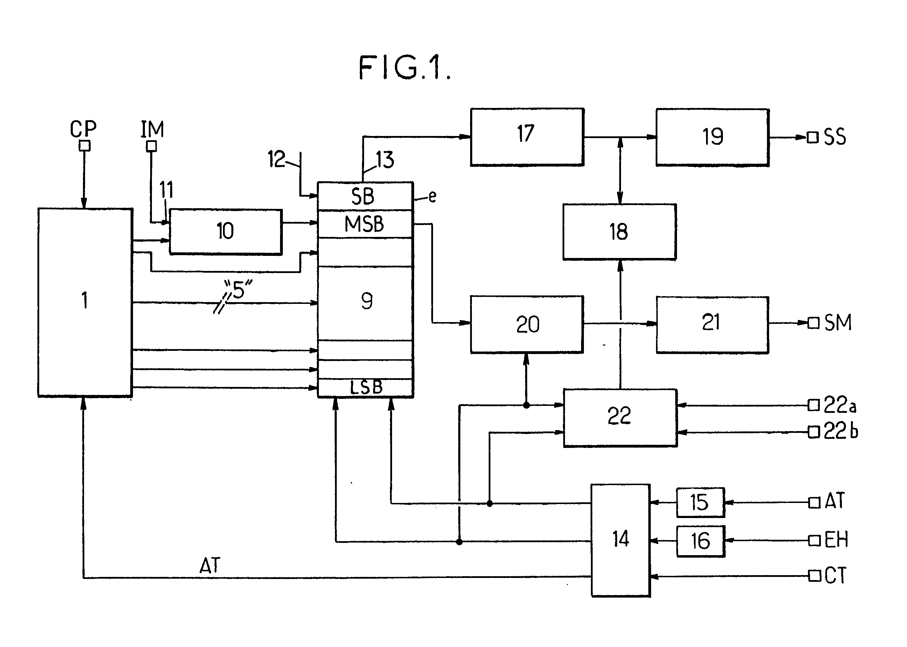

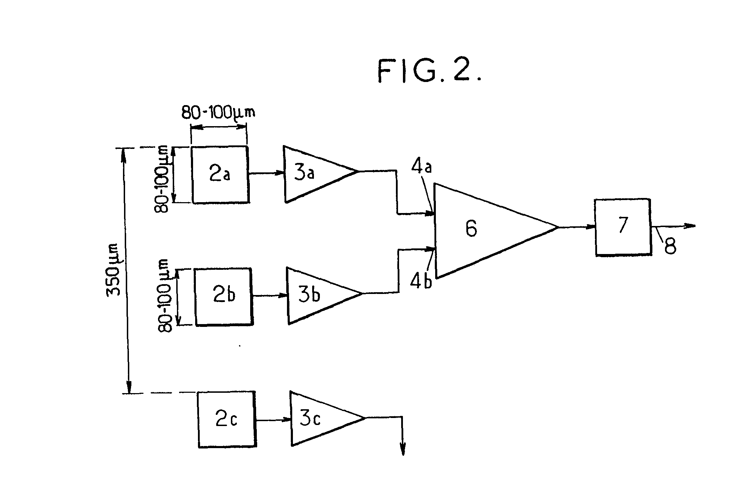

En se référant tout d'abord aux figures 1 et 2, qui illustrent respectivement l'ensemble et une partie d'un dispositif de lecture, entièrement intégré, pour 8—10 bits, avec sortie série, on voit que ce dispositif comporte un système 1 avec 10 voies de lecture, une de ces voies étant détaillée sur la figure 2.

Chaque voie de lecture comporte tout d'abord une paire de photodiodes 2a, 2b de 80 à 100 microns au carré, travaillant en différentiel, l'une des diodes 2a lisant une des pistes codées, tandis que l'autre diode 2b lit une piste associée portant des zones complémentaires aux zones correspondantes de la première piste.

La sortie de chacune des diodes 2a, 2b est amplifiée dans un amplificateur 3a, 3b, et les sorties des deux amplificateurs sont connectées chacune à une entrée 4a, 4b d'un comparateur 6.

La sortie du comparateur 6, qui est un signal alternatif, est traitée par un trigger 7 du type bascule de Schmitt dont la sortie est constituée par un signal rectangulaire.

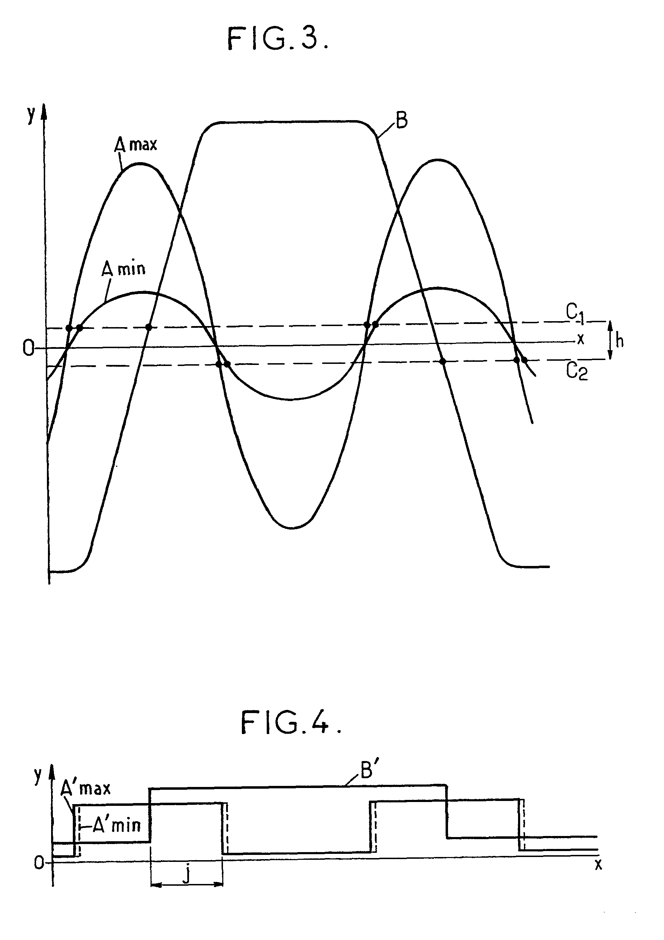

Le comparateur 6 comporte une hystérésis pour éviter les oscillations au voisinage de l'équilibre, comme cela va être expliqué maintenant avec référence aux figures 3 et 4.

Toutefois pour en terminer avec la description de la figure 2, on signalera que sur celle-ci on a représenté une partie d'une voie voisine, à savoir la photodiode 2c et l'amplificateur 3c de celle-ci, et on a porté les distances approximatives concernant les photodiodes pour montrer le faible encombrement des dix paires de photodiodes, On voit en particulier que la largeur d'une voie est de 350 microns.

Sur la figure 3 on a illustré deux signaux d'amplitudes extrêmes, A max et A min, sortant de l'amplificateur différentiel 6 et représentant la sortie d'une voie de lecture. Le signal B représente la sortie de la voie suivante dans l'ordre des bits de représentativité croissante et a donc une fréquence égale à la moitié de la fréquence du signal A max ou A min. On pourra noter que le signal B a subi un écrêtage des amplitudes supérieures en valeur absolue.

L'hystérésis est représentée par la variation h d'amplitude entre les points de basculement du trigger 7 à la montée (horizontale $C_1$) et à la descente (horizontale $C_2$). Ces deux horizontales $C_1$ et $C_2$ sont illustrées en traits interrompus de part et d'autre de l'axe Ox des abscisses, les amplitudes étant portées suivant l'axe des ordonnées Oy. On a indiqué par des points le croisement des courbes A max, A min et B avec l'horizontale $C_1$ à la montée et avec l'horizontale $C_2$ à la descente. Ce sont les points de basculement du trigger 7.

Les signaux représentés sur la figure 3 constituent les entrées des triggers ou bascules de Schmitt 7 de chaque voie, alors que sur la figure 4 on a représenté les sorties de ces triggers, sorties qui sont constituées par des signaux rectangulaires. A la sortie d'un trigger. A max est devenu A'max, tandis que A min est devenu A'min. On s'aperçoit aisément que le signal d'amplitude maximale A max et le signal d'amplitude minimale A min sont transformés en signal A'max et signal A'min respectivement, avec simplement un très léger décalage dans le temps, le rapport cyclique pour A'max et A'min étant indépendant de l'amplitude du signal d'entrée.

Sur la figure 4 on a également illustré le signal B' de sortie du trigger 7 correspondant au signal d'entrée B, B' ayant une fréquence moitié de la fréquence de A'max ou A'min. On notera que dans le code Gray un point de codeur a une durée égale à la moitié de la durée d'un signal A'max ou A'min; cette durée est représentée en j sur la figure 4.

On revient maintenant à la description de la figure 1 dont l'ensemble 1 est constitué par 10 voies identiques à la voie 2a—3a, 2b—3b, 6, 7, de la figure 2.

A droite de l'ensemble 1 on a illustré en totalité 5 des 10 voies, les 5 voies du milieu étant figurées par un seul trait horizontal au niveau duquel on a porté l'indication "5" pour bien montrer que l'on a groupé 5 voies.

Les 10 voies attaquent le registre à décalage 9, étant entendu que la première voie, qui correspond au bit le plus significatif du code Gray, à savoir le bit désigné généralement sous l'abréviation anglaise MSB (pour most significant bit), attaque le registre à décalage 9 par l'intermédiaire de l'inverseur 10 qui permet d'inverser le sens de défilement des informations, sous la commande d'un plot d'inversion IM connecté à son entrée 11. Par ailleurs le bit le moins significatif, désigné généralement sous l'indication LSB (pour less significant bit), arrive dans la dernière cellule du registre 9. Le registre 9 comporte en outre un onzième étage e dans lequel est introduit, par un conducteur 12, un bit initial ou de départ SB.

Le registre à décalage 9 reçoit en fait en paralléle les 10 bits d'information depuis MSB jusqu'à LSB et le bit de départ SB, et il a une sortie série 13 qui débite ces 11 bits successivement, à savoir d'abord le bit de départ SB puis les 10 bits d'information, MSB étant en tête et LSB en queue. La sortie du registre 9 est contrôlée par une unité de contrôle 14 déclenchée par une impulsion d'autorisation de transfert à partir du plot AT mise en forme par un trigger 15 et synchronisée par la première impulsion d'horloge qui arrive sur l'entrée d'horloge EH, les informations d'horloge étant également mises en forme pour un trigger 16 avant d'être traitées par l'unité de contrôle 14.

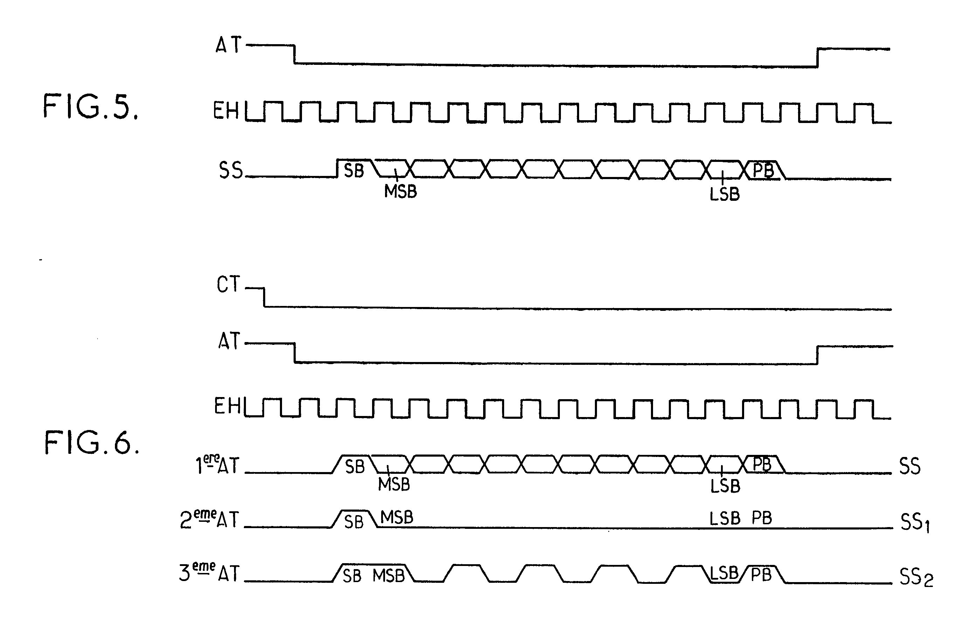

Sur la figure 5 on a représenté de bas en haut l'impulsion d'autorisation de transfert AT, les impulsions d'horloge EH et le signal de sortie SS du dispositif de lecture et comportant donc successivement le bit de départ SB, les bits d'information MSB, ... LSB et enfin un bit de parité PB dont l'introduction sera exposée ci-après. Le signal de sortie du registre 9, qui est dans le code Gray, est converti dans le code binaire naturel dans un transcodeur 17 qui transforme le code Gray en code binaire et qui est constitué par un "OU exclusif".

Par ailleurs, on prévoit un générateur de parité 18, qui est également constitué par un "OU exclusif" et qui engendre un bit de parité assurant que le nombre de "1" transmis dans l'ensemble des 10 bits d'information et du bit de départ est toujours impair ou toujours pair (suivant le choix effectué). Ce bit de parité sert de contrôle; en effet si le nombre de "1" n'a pas la parité désirée, cela signifie qu'il y a eu une erreur de transmission. Le bit de parité est ajouté en tant que 12ème bit aux 11 bits sortant du transcodeur Gray/ binaire 17, l'ensemble des 12 bits arrivant à l'étage de sortie 19 qui débite le signal de sortie SS du dispositif de lecture, signal SS illustré en bas de la figure 5.

L'unité de contrôle 14 est également attaquée par une commande de test à partir du plot CT, commande qui permet de tester le fonctionnement du dispositif de lecture en contrôlant la réception de deux mots (un mot étant constitué par la succession des 12 bits d'un signal SS) bien caractéristiques lorsque la commande CT est activée et qu'elle fait parvenir trois impulsions AT successives d'autorisation de transfert, comme illustré sur la figure 6 sur laquelle on retrouve les impulsions d'autorisation de transfert AT et d'horloge EH avec, en plus, la commande de test CT et les trois impulsions AT successives, la première produisant le signal de sortie SS de la figure 5, alors que les deuxième et troisième impulsions AT produisent des signaux SS1 et SS2 correspondant aux deux mots caractéristiques. En fait les signaux AT sont appliqués par l'unité de contrôle 14 à la partie initiale de l'ensemble de lecture 1, à savoir soit aux diodes telles que 2a et 2b, soit à l'entrée des amplificateurs, tels que 3a et 3b, de manière à provoquer finalement l'application sur les amplificateurs, tels que 3a et 3b, d'un signal simulant soit un bit "0" soit un bit "1".

Le dispositif de lecture de la figure 1 comporte en outre avantageusement une mémoire tampon 20 pour le bit le plus significatif MSB, mémoire tampon qui est également commandée par l'unité de contrôle 14 qui contrôle la sortie de la mémoire tampon vers un étage de sortie 21 qui débite un signal de sortie SM correspondant au bit le plus significatif. L'information SM permet, dans certaines applications, de cascader plusieurs circuits, notamment dans le cas de codeurs multitours.

Enfin l'ensemble de la figure 1 comporte avantageusement un compteur 8/10 référencé 22, qui est également contrôlé par l'unité 14 et qui comporte deux entrées de programmation 22a et 22b pour choisir la longueur du mot utile, c'est-à-dire le nombre de bits d'information, à savoir 8 pour 22a et 10 pour 22b. Le compteur 22 commande le générateur de parité 18 de manière que celui-ci introduise un bit de parité au bon endroit du signal série, à savoir après le 8ème ou le 10ème bit d'information qui constitue le LSB effectif (jusqu'à présent on a décrit le dispositif de la figure 1, en supposant que l'on avait des mots comportant 10 bits d'information).

Dans certains cas on peut prévoir un plot de commande CP agissant sur l'ensemble de voies 1 et qui est destiné au contrôle lors de la fabrications pendant la réalisation du circuit intégré selon la figure 1.

L'ensemble du dispositif de la figure 1 comporte donc deux sorties, à savoir la sortie de l'étage 19 qui donne le signal SS constitué successivement par un bit de départ SB, puis par 10 ou 8 bits d'informations MSB ... LSD, et enfin un bit de parité PB, d'une part, et l'étage de sortie 21, d'autre part, qui débite un signal SM représentant le bit le plus significatif MSB.

On notera, comme indiqué précédemment, que l'on peut inverser le sens de défilement des informations, c'est-à-dire commencer par le "0" et terminer par le "$2^n - 1$" au lieu de commencer par le "$2^n - 1$" et terminer par le "0", en actionnant, par la commande IM, l'inverseur 10, et ceci sans avoir à changer la gravure du disque codé en code Gray.

L'ensemble de la figure 1 fonctionne en coopération avec un seul émetteur de lumiére, par exemple une diode AsGa fonctionnant dans le proche infrarouge et alimentée en courant par une simple résistance reliée à la tension Vcc; cette diode éclaire le circuit intégré de la figure 1 à travers une optique convenable et les zones transparentes du disque codé, le circuit intégré de la figure 1 étant protégé soit par un enrobage transparent à l'infrarouge, soit par mise dans un boitier à fenêtre en verre.

Un circuit intégré selon la figure 1 a été effectivement réalisé en technologie bipolaire sur une surface de silicium inférieure à 15 mm². Un tel circuit intégré permet la lecture de 100,000 points par seconde et une transmission jusqu'à une fréquence de 1 MHz (1 Mbit par seconde), la transmission s'effectuant à partir des étages de sortie 19 et 21 par les moyens habituels.

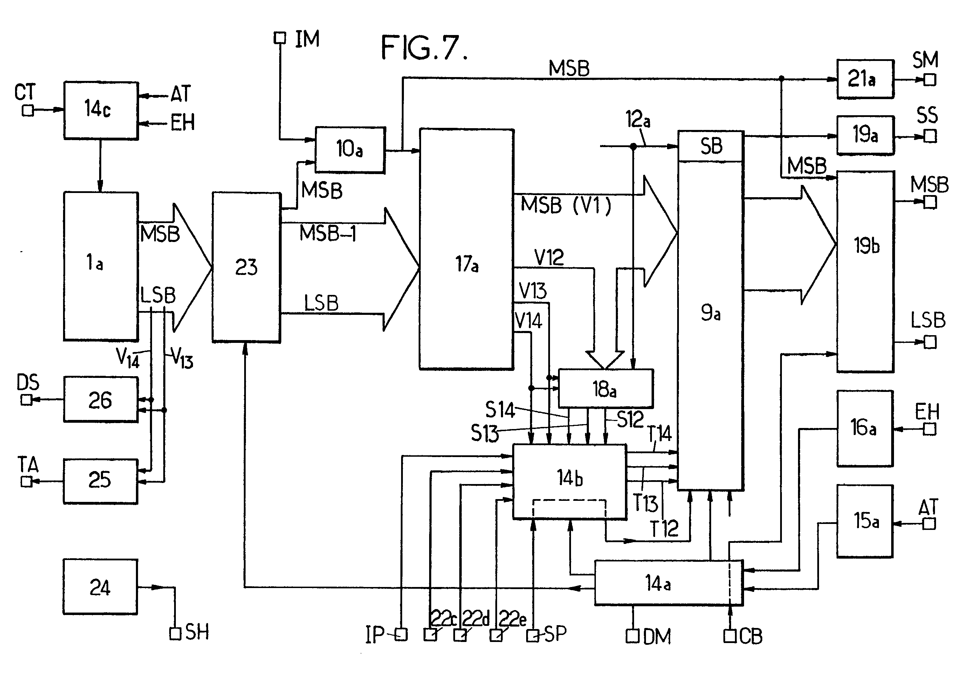

On va décrire maintenant, avec référence à la figure 7, un dispositif de lecture entièrement intégré pour 12 à 14 bits, comportant une sortie parallèle et une sortie série.

Le dispositif comprend tout d'abord un ensemble de lecture 1a, analogue à l'ensemble de lecture 1 de la figure 1, c'est-à-dire comportant pour chaque voie un ensemble selon la figure 2, à part le fait que l'ensemble 1a est prévu pour 14 voies de lecture, alors que l'ensemble 1 de la figure 1 est prévu pour 10 voies.

La sortie sur 14 voies, c'est-à-dire comportant 14 bits depuis le plus significatif MSB jusqu'au moins significatif LSB des bits sortant de l'ensemble 1a, arrive à un verrou d'entrée 23 de 14 bits, du type latch, réalisant la mise en mémoire des 14 bits et permettant de verrouiller l'information lue sur le disque codé, indépendamment de la transmission à partir du dispositif de lecture de la figure 7. Ceci permet par exemple, dans le cas d'un robot comportant plusieurs disques codés destinés à repérer la position angulaire de plusieurs éléments, de pouvoir stocker les lectures des différents disques codés à un même instant, puis de les transmettre de manière que l'unité de traitement des informations reçoive chaque fois la position de tous les organes mobiles à un même instant.

La sortie du verrou 23 est transmise à un transcodeur 17a Gray/binaire de 14 bits fonctionnant en parallèle, en notant toutefois que le MSB traverse, avant d'être appliqué au transcodeur 17a, un inverseur 10a commandable par une entrée IM d'inversion, afin de pouvoir réaliser — du fait de la structure même du code Gray — lorsqu'on le désire, une inversion du sens de défilement des informations.

La sortie du transcodeur 17a est constituée, en binaire naturel, normalement par 14 bits en parallèle, à savoir MSB (voie 1 marquée V1), 11 bits constituant les voies V2 à V12, et enfin éventuellement deux autres bits par les voies V3 et V14 (on verra ci-après que l'on peut passer à volonté de 12 à 14 bits).

Les 12 à 14 bits arrivent finalement sur le registre à décalage 9a, analogue au registre à décalage 9 de la figure 1, mais comportant 16 entrées parallèles et une double sortie, à savoir une sortie série et en outre une sortie parallèle, ces sorties attaquant respectivement les étages de sortie 19a pour la sortie série et 19b pour la sortie parallèle. Le registre à décalage comporte un étage supplémentaire recevant, par l'entrée 12a, un bit initial de départ SB, ce bit initial n'étant transféré que vers la sortie série 19a et dans ce cas en tête des bits d'information MSB à LSB, pour constituer un signal de sortie SS du type de celui illustré sur la figure 5, à part le fait que le nombre de bits d'information est plus élevé.

Comme dans le mode de réalisation de la figure 1, on prévoit une sortie particulière pour le bit MSB qui, à travers une mémoire tampon non représentée, arrive à partir de la sortie de l'inverseur 10a sur l'étage de sortie 21a correspondant à l'étage de sortie 21 de la figure 1.

Quant à la sortie parallèle 19b, elle est constituée par un "port" de sortie parallèle du type 3 états de 15 bits (14 bits d'informations et 1 bit de parité dont il sera question ci-après).

A la place de l'unité de contrôle 14 de la figure 1, le dispositif de la figure 7 comporte trois unités de contrôle, à savoir un séquenceur 14a, un programmateur 14b et une unité de test 14c.

Le séquenceur 14a, qui organise le fonctionnement du circuit de la figure 7, reçoit, à travers des triggers 15a et 16a, respectivement les impulsions d'autorisation de transfert AT et les impulsions d'horloge EH; il reçoit en outre des impulsions de demande de mesure DM et de commande CB de la sortie 3 états, pour la sortie parallèle 19b.

Le programmateur 14b permet de conditionner le dispositif de la figure 7 pour qu'il puisse fonctionner en 12, 13 ou 14 bits. A cet effet il a trois entrées 22c, 22d et 22e, d'une part, et un plot de programmation IP, d'autre part, qui permet d'inverser la parité et il est sous le contrôle du séquenceur 14. Ce programmateur est également connecté au générateur de parité 18a par trois connexions correspondant au choix de 12, 13 et 14 bits et notées S12, S13 et S14, et il contrôle le registre 9a par trois connexions correspondant au choix de 14, 15 et 16 bits et respectivement désignées T12, T13, T14. Le programmateur commande le transfert des bits de rang 12, 13 et 14 et l'introduction, par l'unité 18a, du bit de parité après le 12ème, le 13ème ou le 14ème bit d'information.

Quant à l'unité de test 14c, dont les entrées sont connectées aux plots AT et EH à travers les triggers 15a et 16a, elle comporte une troisième entrée constituant la commande de test CT. L'unité de test 14c agit sur la partie initiale des voies 1a pour commander la simulation des bits "1" ou "0" aux entrées des amplificateurs, tels que 2a et 2b de la figure 2.

Enfin le dispositif de la figure 7 peut comprendre les trois unités suivantes:

une horloge interne 24 d'entrée SH, qui peut attaquer le plot d'entrée EH directement:

un tachymètre 25 recevant la sortie des voies 13 et 14, notées $V_{13}$ et $V_{14}$, de l'unité 1a et débitant sur un plot TA la vitesse de rotation relative du disque, information supplémentaire qui peut être intéressante dans certains cas et qui est obtenue sans nécessiter un système tachymétrique spécial, comme c'est le cas avec les dispositifs de lecture de code de la technique antérieure;

une unité 26 qui reçoit également les voies $V_{13}$ et $V_{14}$ pour détecter le sens de déplacement relatif du disque codé, cette indication étant disponible en DS à la sortie de l'unité 26.

On notera que l'on double la fréquence des impulsions par un "OU exclusif" intégré dans chacune des unités 25 et 26.

Comme dans le cas du dispositif de la figure 1, il faut ajouter au dispositif de la figure 7 un émetteur de lumière avec son optique.

Le circuit de la figure 7 accomplit toutes les fonctions indiquées ci-dessus pour le dispositif de la figure 1 avec, en plus, la fonction de détermination du sens de rotation et de la vitesse de rotation.

Réalisé suivant la technologie CMOS, un dispositif de la figure 7 présente une faible consommation et peut être construit sur une surface de silicium de 15 mm² seulement. Il permet une lecture à plus de 100,000 points par seconde avec sortie des informations en deux microsecondes en parallèle et/ou transmission en série jusqu'à une vitesse de 1 Mbit par seconde.

On voit donc que l'invention permet de réaliser un dispositif de lecture optique complètement intégré sur une ou éventuellement un petit nombre de puces avec un encombrement et un coût très réduits et avec une fiabilité et une sécurité très grandes. En outre le circuit peut réaliser des fonctions supplémentaires telles qu'une fonction de test du circuit et aussi la détermination du sens et de la vitesse de rotation.

Un dispositif selon l'invention peut être appliqué particulièrement aux montages décrits dans les demandes de brevet français de la demanderesse FR—A—2.544.895 publiée le 26 octobre 1984, et FR—A—2.567.266 publiée le 10 janvier 1986, ainsi que FR—A—2.575.283 et FR—A—2.575.285, ces deux dernières publiée le 27 juin 1986, comportant chacune un lecteur optoélectronique 10 qui peut être réalisé comme décrit ci-dessus.

**Revendications**

1. Dispositif de lecture de code optique — destiné à coopérer avec un élément codé en mouvement relatif par rapport à ce dispositif de lecture et comportant une série de n pistes codées avec une succession de zones élémentaires de deux types de retransmission de lumière reçue qui — comprend;

une source unique de lumière pour éclairer la série de pistes,

des moyens de détermination d'éclairement pour déterminer si de la lumière est ou n'est pas retransmise par une zone élémentaire observée de chacune des pistes,

un registre à décalage (9; 9a) à entrées parallèles recevant chacune un signal binaire indiquant si de la lumière est ou n'est pas retransmise par une telle zone élémentaire et à sortie série, et

au moins une unité de contrôle (14; 14a, 14b, 14c) recevant des impulsions d'horloge à partir d'une horloge (24) et des impulsions de transfert, la sortie de cette unité de contrôle commandant le fonctionnement du registre à décalage,

caractérisé en ce que ledit élément codé qui comporte, en plus de la série de n pistes codées, une second série de n pistes, chacune de ces dernières pistes étant associée et codée complémentairement à une des pistes de la première série, et en ce que lesdits moyens de détermination d'éclairement sont portés par 1 à p puces (p étant un nombre entier petit) et comportent en combinaison:

pour chaque paire de pistes associées de l'élément codé, une paire de photodiodes (2a, 2b), un amplificateur différentiel (3a, 3b, 6) dont les deux entrées reçoivent les signaux émis par les deux photodiodes, un trigger (7) donnant un front avant raide aux signaux reçus de la sortie de l'amplificateur différentiel,

ledit registre à décalage, les entrées parallèles de celui-ci étant connectées à la sortie d'un amplificateur différentiel (3a, 3b, 6) à travers le trigger associé, l'ensemble de ces sorties étant constitué par les bits représentatifs du code de chaque paire de piste associés pour la zone lue, tandis que la sortie série dudit registre à décalage débite tous les bits correspondant à une position relative de l'élément codé et du dispositif de lecture, ainsi qu'un bit supplémentaire initial ou de départ, et

des moyens (CT) pour envoyer sur les photodiodes ou les entrées des amplificateurs différentiels des signaux aptes à simuler, sur la sortie des diodes ou l'entrée des amplificateurs respectivement, à volonté le niveau de bit ''0'' ou ''1''.

2. Dispositif selon la revendication 1, caractérisé en ce que l'élément porteur de code est un disque et la lecture des zones opaques ou transparentes de celui-ci est effectuée par diascopie, c'est-à-dire par lumière transmise ou non transmise à travers les zones respectivement transparentes et opaques du disque.

3. Dispositif selon la revendication 1 ou 2, caractérisé en ce que l'amplificateur différentiel est constitué par deux amplificateurs (3a, 3b) en parallèle, recevant chacun la sortie d'une des deux photodiodes de la paire de photodiodes accouplées, et par un comparateur (6) dont les deux entrées (4a, 4b) reçoivent chacune la sortie d'un des deux amplificateurs précités disposés en parallèle.

4. Dispositif selon l'une quelconque des revendications précédentes, caractérisé en ce qu'on prévoit un décalage d'amplitude (h), dans le basculement provoqué par la partie montante, d'une part, et la partie descendante, d'autre part, du signal sortant de l'amplificateur différentiel, c'est-à-dire une hystérésis du comparateur, dans le mode de réalisation préféré de cet amplificateur différentiel.

5. Dispositif selon l'une quelconque des revendications précédentes, caractérisé en ce que le registre à décalage comprend une entrée spéciale (12; 12a), en plus des entrées alimentées par les amplificateurs différentiels, notamment les comparateurs, cette entrée spéciale étant alimentée pour produire un bit initial ou de départ (SB) qui précéde les bits d'information sur les zones de l'élément codé effectivement lues.

6. Dispositif selon l'une quelconque des revendications précédentes, caractérisé en ce qu'il comporte un transcodeur série (17) de conversion du code Gray en code binaire naturel opérant, sous le contrôle de l'unité de contrôle, la conversion des bits en code Gray sortant du registre à décalage en bits en code binaire naturel disponibles sur un étage de sortie (19; 19a) du dispositif de lecture.

7. Dispositif selon l'une quelconque des revendications précédentes, caractérisé en ce qu'il comporte un transcodeur paralléle (17a) de conversion du code Gray en code binaire naturel opérant la conversion des bits en code Gray sortant des triggers en bits en code binaire naturel disponibles sur un étage de sortie (19b) du dispositif de lecture.

8. Dispositif selon l'une quelconque des revendications précédentes, caractérisé en ce qu'il comporte un générateur de parité (18; 18a) qui engendre un bit de parité (PB) assurant que le nombre de "1" transmis par le registre à décalage à l'étage de sortie, éventuellement à travers le transcodeur de code Gray en code binaire naturel, présente une parité déterminée étant ce nombre pair ou impair, ce bit de parité étant introduit après les bits d'information.

9. Dispositif selon l'une quelconque des revendications précédentes, caractérisé en ce qu'il comporte un compteur programmable apte à choisir le nombre de bits d'information utiles en fonction du nombre de pistes effectivement lues, ce compteur commandant, le générateur de parité pour la génération du bit de parité à l'instant désiré après le nombre de bits d'information sélectionné.

10. Dispositif selon l'une quelconque des revendications précédentes, caractérisé en ce qu'il comporte une mémoire tampon (20) recevant sur son entrée le bit le plus significatif (MSB) du registre à décalage pour chaque succession de bits correspondant à une position déterminée qui est lue, et un étage de sortie (21; 21a), connecté à la sortie de la mémoire tampon, pour la sortie de ce bit le plus significatif, la mémoire tampon étant contrôlée par l'unité de contrôle en ce qui concerne sa sortie.

11. Dispositif selon l'une quelconque des revendications précédentes, caractérisé en ce qu'il comporte un ensemble (23) de verrous d'entrée disposés entre la sortie des amplificateurs différentiels, notamment des comparateurs, et l'entrée du registre à décalage, de manière à pouvoir transmettre les sorties des amplificateurs différentiels, respectivement des comparateurs, a un instant bien déterminé.

12. Dispositif selon l'une quelconque des revendications précédentes, caractérisé en ce qu'il comporte un inverseur (10; 10a) du bit le plus significatif, commandable pour réaliser, lorsqu'on le désire, l'inversion de ce bit avant qu'il soit appliqué au registre à décalage.

**Patentansprüche**

1. Lesegerät für optischen Kode — zum Zusammenwirken mit einem kodierten Element bei einer Bewegung relativ zu diesem Lesegerät, mit einer Reihe von n Spuren, die mit einer Folge von Elementarzonen zweier Lichtübertragungsarten kodiert sind — welches aufweist:
eine einzige Lichtquelle zum Beleuchten der Reihe von Spuren,
Mittel zum Bestimmen der Beleuchtung, wenn durch eine beobachtete Elementarzone jeder der Spuren Licht übertragen oder nicht übertragen wird,
ein Schieberegister (9; 9a) mit parallelen Eingängen, die jeweils ein binäres Signal empfangen, das anzeigt, ob das Licht durch eine solche Elementarzone übertragen wurde oder nicht, und mit einem seriellen Ausgang, und
wenigstens eine Steuereinheit (14; 14a, 14b, 14c), die Taktimpulse von einem Taktgeben (24) und Transferimpulse empfängt und deren Ausgang den Betrieb des Schieberegisters steuert,
dadurch gekennzeichnet, daß das erwähnte kodierte Element zusätzlich zu der Reihe von n kodierten Spuren eine zweite Reihe von n Spuren aufweist, wobei jede dieser zuletzt erwähnten Spuren zugeordnet und komplementär kodiert ist zu einer der Spuren der ersten Reihe, und daß die Beleuchtungsbestimmungsmittel von 1 bis p Chips getragen werden (wobei p eine kleine ganze Zahl ist) und in Kombination aufweisen:
für jedes Paar der einander zugeordneten Spuren des kodierten Elements ein paar Fotodioden (2a, 2b), einen Differenzverstärker (3a, 3b, 6), dessen beide Eingänge die von den beiden Fotodioden erzeugten Signale empfangen, einen Trigger (7), der den vom Ausgang des Differenzverstärkers empfangenen Signalen eine steile Vorderflanke erteilt,
das erwähnte Schieberegister, dessen parallele Eingänge mit dem Ausgang eines Differenzverstärkers (3a, 3b, 6) über den angeschlossenen Trigger verbunden sind, wobei die Gesamtheit der Ausgänge durch die Bits gebildet ist, die den Kode jedes Paares der einander zugeordneten Spuren für die gelesene Zone darstellen, so daß der serielle Ausgang des erwähnten Schieberegisters alle Bits abgibt, die einer Relativlage des kodierten Elements und des Lesegeräts entsprechend, ebenso wie ein Anfangs- oder Start-Ergänzungsbit, und
Mittel (CT) zur Beaufschlagung der Fotodioden oder Eingänge der Differenzverstärker mit Signalen, die geeignet sind, jeweils am Ausgang der Dioden oder am Eingang der Verstärker, den Bitpegel "0" oder "1" zu simulieren.

2. Gerät nach Anspruch 1, dadurch gekennzeichnet, daß das Kodeträgerelement eine Scheibe ist und das Lesen ihrer opaken oder transparenten Zonen mittels Durchleuchtung bewirkt wird, d.h. durch Licht, das jeweils durch die transparenten oder opaken Zonen der Scheibe hindurchgeht oder nicht.

3. Gerät nach Anspruch 1 oder 2, dadurch gekennzeichnet, daß der Differenzverstärker durch zwei parallele Verstärker (3a, 3b), denen jeweils das Ausgangssignal einer der beiden Fotodioden des angeschlossenen Fotodiodenpaares zugeführt wird, und durch einen Vergleicher (6) gebildet ist, dessen beiden Eingängen (4a, 4b) jeweils das Ausgangssignal eines der beiden vorgeschalteten parallelen Verstärker zugeführt wird.

4. Gerät nach einem der vorangehenden Ansprüche, dadurch gekennzeichnet, daß in dem durch einerseits den ansteigenden Teil und andererseits den abfallenden Teil des Ausgangssignals des Differenzverstärkers bewirkten Kippvorgang eine Amplitudenverschiebung (h) vorgesehen ist, d.h. eine Hysterese des Vergleichers bei der bevorzugten Ausführungsform des Differenzverstärkers.

5. Gerät nach einem der vorangehenden Ansprüche, dadurch gekennzeichnet, daß das Schieberegister zusätzlich zu dem durch die Differenzverstärker, insbesondere die Vergleicher, beaufschlagten Eingängen einen Spezialeingang (12; 12a) aufweist, der zur Erzeugung eines Anfangs- oder Startbits (SB) beaufschlagt wird, das den Informationsbits in den effektiv gelesenen Zonen des kodierten Elements vorausgeht.

6. Gerät nach einem der vorangehenden Ansprüche, dadurch gekennzeichnet, daß es einen seriellen Kodeumsetzer (17) zum Umsetzen eines Gray-Kode in den natürlich Binärkode aufweist, wobei der Kodeumsetzer, gesteuert durch die Steuereinheit, die Umsetzung von Bits im Gray-Kode, die am Schieberegister austreten, in Bits im natürlichen Binärkode bewirkt, die an einer Ausgangsstufe (19; 19a) des Lesegeräts zur Verfügung stehen.

7. Gerät nach einem der vorangehenden Ansprüche, dadurch gekennzeichnet, daß sie einen parallelen Kodeumsetzer (17a) zum Umsetzen des Gray-Kode in den natürlichen Binärkode aufweist, der die Umsetzung von Bits im Gray-Kode am Ausgang von Triggern in Bits im natürlichen Binärkode bewirkt, die an einer Ausgangsstufe (19b) des Lesegeräts zu Verfügung stehen.

8. Gerät nach einem der vorangehenden Ansprüche, dadurch gekennzeichnet, daß es einen Paritätsgenerator (18; 18a) aufweist, der ein Paritätsbit (PB) erzeugt, das sicherstellt, daß die Anzahl der I-Bits, die durch das Schieberegister an der Ausgangsstufe, gegebenenfalls über den Kodeumsetzer vom Gray-Kode in den natürlich Binärkode, abgegeben werden, eine vorbestimmte Parität aufweisen, wobei ihre Anzahl entweder geradzahlig oder ungeradzahlig ist, und daß das paritätsbit nach den Informationsbits eingefügt ist.

9. Gerät nach einem der vorangehenden Ansprüche, dadurch gekennzeichnet, daß es einen programmierbaren Zähler aufweist, der die Anzahl der verwendbaren Informationsbits in Abhängigkeit von der Anzahl der effektiv gelesenen Spuren zu wählen vermag und den Paritätsgenerator zur Erzeugung des Paritätsbits im gewünschten Augenblick nach der Wahl der Anzahl der Informationsbits auslöst.

10. Gerät nach einem der vorangehenden Ansprüche, dadurch gekennzeichnet, daß es einen Zwischenspeicher (20) aufweist, der an seinem Eingang das höchststehende Bit (MSB) des Schieberegisters bei jeder Bitfolge empfängt, die einer vorbestimmten gelesenen Position entspricht, und eine am Ausgang des Zwischenspeichers angeschlossene Ausgangsstufe (21; 21a) für die Ausgabe des höchststelligen Bits aufweist, wobei der Zwischenspeicher hinsichtlich seiner Ausgabe durch die Steuereinheit gesteuert wird.

11. Gerät nach einem der vorangehenden Ansprüche, dadurch gekennzeichnet, daß es eine Anordnung (23) aus Eingangsverriegelungsgliedern aufweist, die zwischen dem Ausgang der Differenzverstärker, insbesondere der Vergleicher, und dem Schieberegistereingang derart angeordnet sind, daß sie die Ausgangssignale der Differenzverstärker, bzw. der Vergleicher, in einem genau vorbestimmten Zeitpunkt übertragen.

12. Gerät nach einem der vorangehenden Ansprüche, dadurch gekennzeichnet, daß es eine Umkehrstufe (10; 10a) für das höchststellige Bit aufweist, die derart steuerbar ist, daß sie, wenn es erwünscht ist, die Umkehrung dieses Bits bewirkt, bevor es dem Schieberegister zugeführt wird.

**Claims**

1. A device for reading visual code — intended to co-operate with an element coded for relative movement in respect of this reading device and comprising a series of n coded tracks with a succession of elementary zones of two types of retransmission of received light — comprising:

a single light source for illuminating the series of tracks

means of determining the lighting to determine whether the light is or is not retransmitted by an observed elementary zone of each of the tracks,

a shift register (9; 9a) having parallel inputs each receiving a binary signal indicating whether the light is or is not retransmitted by such or such an elementary zone and having a series output and

at least one monitoring unit (14a; 14a, 14b, 14c) receiving clock pulses from a clock (24) and transfer pulses, the output from which monitoring unit controlling the operation of the shift register,

characterised in that the said coded element which comprises in addition to the series of n coded tracks a second series of n tracks, eech of these latter tracks being associated and additionally coded to one of the tracks of the first series and in that the said means of determining the lighting are carried by one to p chips (p being a small whole number) and comprise in combination:

for each pair of associated tracks on the coded element one pair of photodiodes (2a, 2b), a differential amplifier (3a, 3b, 6) the two inputs of which receive the signals emitted by the two photodiodes, a trigger (7) providing a steep leading front for the signals received from the output from the differential amplifier,

the said shift register, the parallel inputs thereof being connected to the output of a differential amplifier (3a, 3b, 6) through the associated trigger, all of these outputs being constituted by bits representing the code of each pair of associated tracks for the zone being read, while the series output of the said shift register delivers all the bits corresponding to a relative position of the coded element and of the reading device as well as a supplementary initial or starting bit, and

means (CT) of sending via the photodiodes or the inputs of the differential amplifiers signals which are adapted to simulate, on the output of the diodes or the input of the amplifiers respectively, the bit level "0" or "1" at will.

2. A device according to claim 1, characterised in that the code carrying element is a disc and reading of the opaque or transparent zones thereon is carried out by diascopy, that is to say by light being transmitted or not transmitted via the transparent and opaque zones of the disc reapectively,.

3. A device according to claim 1 or 2, characterised in that the differential amplifier consists of two amplifiers (3a, 3b) in parallel, each receiving the output from one of the two photodiodes of the pair of coupled photodiodes and by a comparator (6) the two inputs (4a, 4b) of which each receive the output from one of the two aforesaid amplifiers which are disposed in parallel.

4. A device according to any one of the preceding claims, characterised in that an offset of amplitude (h) is provided in the changeover caused by the rising part on the one hand and the descending part on the other of the signal emerging from the differential amplifier, that is to say a hystereis in the comparator, in the preferred embodiment of this differential amplifier.

5. A device according to any one of the preceding claims, characterised in that the shift register comprises a special input (12; 12a) in addition to the inputs aupplied by the differential amplifiers, particularly the comparators, this special input being supplied in order to produce an initial or starting bit (SB) which precedes the data bits on the zones of tha coded element which are effectively read.

6. A device according to any one of the preceding claims, characterised in that it comprises a series transcoder (17) for conversion from the Gray code to the natural binary code and which, under the control of the monitoring unit, carries out conversion of Gray code bits emerging from the shift register to natural binary code bits available at an output stage (19; 19a) of the reading device.

7. A device according to any one of the preceding claims, characterised in that it comprises a parallel transcoder (17a) for conversion from the Gray code to natural binary code, carrying out conversion of the Gray code bits emerging from the triggers into natural binary code bits available at an output stage (19b) of the reading device.

8. A device according to any one of the preceding claims, characterised in that it comprises a parity generator (18; 18a) which engenders a parity bit (PB) ensuring that the number "1" transmitted by the shift register to the output stage, possibly via the Gray code:natural binary code transcoder, has a specific parity, this number being even or odd and this parity bit being introduced after the data bits.

9. A device according to any one of the preceding claims, characterised in that it comprises a programmable counter adapted to choose the number of data bits which are useful as a function of the number of tracks effectively read, the said counter operating the parity generator for generation of the parity bit at the desired moment after the selected number of data bits.

10. A device according to any one of the preceding claims, characterised in that it comprises a buffer mamory (20) receiving at its input the most significant bit (MSB) of the shift register for each succession of bits corresponding to a specific position which is read, and an output stage (21; 21a) connected to the output from the buffer memory for the output of this most significant bit, the buffer memory being monitored by the monitor unit with regard to its output.

11. A device according to any one of the preceding claims, characterised in that it comprises an assembly (23) of input locks disposed between the output of the differential amplifiers, particularly the comparators, and the input of the shift register, in order to be able to transmit the outputs from the differential amplifiers or comperators respectively at any specific moment.

12. A device according to any one of the preceding claims, characterised in that it comprises a switch (10; 10a) for reversing the most significant bit, and which can be controlled so that when it is desired the inversion of this bit can be carried out before it is applied to the shift register.

FIG.1.

FIG. 2.

2

# FIG.3.

# FIG.4.

FIG.5.

FIG.6.

FIG.7.